# EUROPEAN PATENT APPLICATION

(11) **EP 3 156 813 A1**
(43) Date of publication of application: **19.04.2017**
(21) Application number: 16193217.3
(22) Date of filing: 11.10.2016
(51) Int. Cl.: G01R 33/00, G01R 15/18, G01R 19/00, G01R 19/25, H01F 3/14, H01F 5/02, H01F 27/30

(54) **CURRENT DETERMINING DEVICE AND METHOD**

(30) Priority: 16.10.2015 GB 201518372
(71) Applicant: Johnson Electric S.A., 3280 Murten (CH)
(72) Inventor: Connell, Richard, Hong Kong (HK)
(74) Representative: Hocking, Adrian Niall

(57) **Abstract**

A current determining device (10) comprises a flat-sided primary conductor (12) having two end faces (20) between which a current can flow in a flow direction (46), and at least two flat sides in parallel with the flow direction (46). A first field-modifying element (14) formed of a magnetic material is located at or adjacent to a first said flat side of the primary conductor (12), and a second field-modifying element (16) formed of a magnetic material and located at or adjacent to the second said flat side of the primary conductor (12). At least one sensing coil (18a, 18b) is also provided at or adjacent to the primary conductor (12) and the first and second field-modifying elements (14, 16), and has a coil axis (40) which extends between planes (42) of the two flat sides. An electromagnetic field F formed by current flowing in the flat-sided primary conductor (12) is modified by the first and second field-modifying elements (14, 16) to extend more in parallel or substantially in parallel with the coil axis (40) of the sensing coil (18a, 18b), whereby an induced electromotive-force at the sensing coil (18a, 18b) has improved proportionality with the current flowing in the flat-sided primary conductor (12).

## Description

### FIELD OF THE INVENTION

The present invention relates to a current determining device, to a corrector circuit in combination with such a device, and to a method of improving current determination using the device. Furthermore, the invention relates to a method of improving proportionality of an induced electromagnetic field in a sensing coil relative to a current flowing in a primary conductor using the current determining device, and to a method of improving sensing coil resolution when determining current flowing in a current-carrying primary conductor using such a current determining device.

### BACKGROUND OF THE INVENTION

From classical principles of electromagnetic induction, it is understood that an electromagnetic field is generated by a current-carrying conductor, such as an electrical wire. It is also known that such an electromagnetic field will induce a measurable voltage signal in a neighbouring sensing coil. The signal outputable by the sensing coil is at least in part related to the magnitude of the current flowing in the current-carrying conductor.

It would be beneficial to be able to improve or optimise the association between the sensing coil and the current-carrying conductor, thereby allowing a size of the sensing coil to be reduced without adversely affecting a required resolution or accuracy of the outputted signal. This consequently enables a reduction in size not only of the sensing coil but also, if necessary, the current-carrying conductor being monitored. A size reduction without a reduction in accuracy translates into a material cost-saving.

### SUMMARY OF THE INVENTION

The present invention therefore seeks to provide a solution to this problem.

According to a first aspect of the invention, there is provided a current determining device comprising: a flat-sided primary conductor having two end faces between which a current can flow in a flow direction and at least two flat sides in parallel with the flow direction; a first field-modifying element formed of a magnetic material and located at or adjacent to a first said flat side of the primary conductor; a second field-modifying element formed of a magnetic material and located at or adjacent to the second said flat side of the primary conductor; and at least one sensing coil at or adjacent to the primary conductor and the first and second field-modifying elements, and having a coil axis which extends between planes of the two flat sides, wherein an electromagnetic field formed by current flowing in the flat-sided primary conductor is modified by the first and second field-modifying elements to extend more in parallel or substantially in parallel with the coil axis of the sensing coil, whereby an induced-EMF at the sensing coil has improved proportionality with the current flowing in the flat-sided primary conductor.

There is also provided a current determining device comprising: a flat-sided primary conductor having two end faces between which a current can flow in a flow direction and at least two flat sides in parallel with the flow direction; a first field-modifying element formed of a magnetic material and located at or adjacent to a first said flat side of the primary conductor; a second field-modifying element formed of a magnetic material and located at or adjacent to the second said flat side of the primary conductor; and at least one sensing device at or adjacent to the primary conductor and the first and second field-modifying elements, and extending between or substantially between planes of the two flat sides, wherein an electromagnetic field formed by current flowing in the flat-sided primary conductor is modified by the first and second field-modifying elements to extend more in parallel or substantially in parallel with the sensing device, whereby an induced-EMF at the sensing device has improved proportionality with the current flowing in the flat-sided primary conductor.

According to a second aspect of the invention, there is provided a corrector circuit in combination with a current determining device according to the first aspect of the invention, the corrector circuit having an input for receiving an output signal corresponding to an induced-EMF from the or each sensing coil, and a differential-phase correction integrator circuit having an op-amp and which alters a phase-difference of the output signal, so that an altered output signal can be formed in-phase or substantially in-phase with the current in the primary conductor.

Preferably, the corrector circuit includes a scaling calibration circuit for calibrating and scaling the altered output signal, the scaling calibration circuit including a further op-amp.

According to a third aspect of the invention, there is provided a method of improving current determination using a current determining device, preferably in accordance with the first aspect of the invention, the method comprising the steps of modifying an electromagnetic field formed by a current-carrying primary conductor by utilising opposing flat sides on the current-carrying primary conductor and associated first and second field-modifying elements, whereby the electromagnetic field is more in parallel or substantially in parallel with a coil axis of an associated sensing coil, thereby improving the proportionality of the induced-EMF at the sensing coil relative to the current flowing in the flat-sided primary conductor.

According to a fourth aspect of the invention, there is provided a method of improving proportionality of an induced-EMF at a sensing coil relative to a current flowing in a primary conductor using a current determining device, preferably in accordance with the first aspect of the invention, the method comprising the steps of: providing opposing flat sides on the primary conductor; and modifying an electromagnetic field formed by the primary conductor when carrying a current by utilising first and second field-modifying elements associated with the said flat sides, whereby the electromagnetic field becomes more in parallel or substantially in parallel with a coil axis of the associated sensing coil.

According to a fifth aspect of the invention, there is provided a method of improving sensing coil accuracy when determining current flowing in a current-carrying primary conductor using a current determining device, preferably in accordance with the first aspect of the invention, the method comprising the steps of modifying an electromagnetic field formed by the current-carrying primary conductor by utilising first and second field-modifying elements associated with opposing flat sides on the current-carrying primary conductor, whereby the electromagnetic field becomes more in parallel or substantially in parallel with a coil axis of the associated sensing coil.

### BRIEF DESCRIPTION OF THE DRAWINGS

The invention will now be more particularly described, by way of example only, with reference to the accompanying drawings, in which:
Figure 1 shows a diagrammatic end-on view of one embodiment of a current determining device, in accordance with the first aspect of the invention and with two sensing coils detached;
Figure 2 is a view similar to that of Figure 1, showing the current determining device with the sensing coils attached;
Figure 3 is a diagrammatic side view of the current determining device, shown in Figure 2; and
Figure 4 is a simplified circuit diagram of the corrector circuit in combination with the current determining device.

### DETAILED DESCRIPTION OF THE PREFERRED EMBODIMENTS

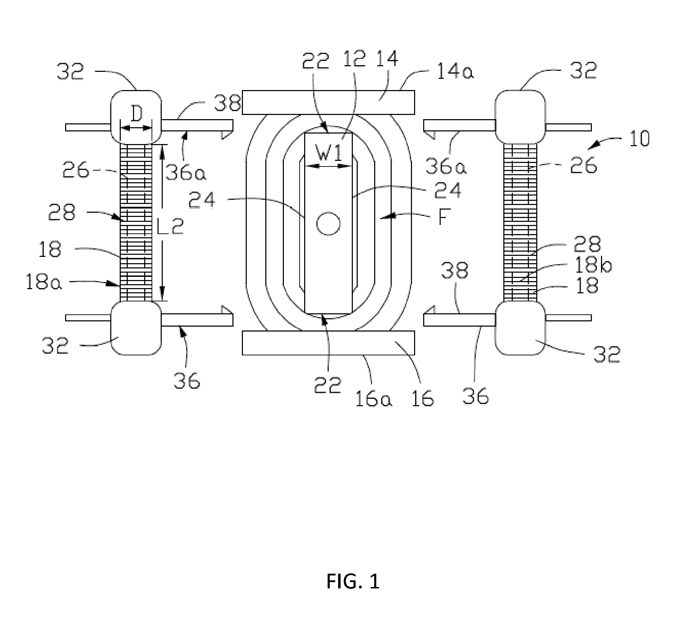

Referring firstly to Figures 1 to 3 of the drawings, there is shown one embodiment of a current determining device 10 which comprises a primary conductor 12, a first field-modifying element 14, a second field-modifying element 16, and two sensing devices 18, which in this case are preferably sensing coils 18a, 18b.

The primary conductor 12 is advantageously a busbar, but may be any other suitable electrically conducting element. The busbar or other suitable primary conductor 12 is, in this case, rigid or at least stiff, and preferably forms part of an electrical disconnect switch or other suitable kind of switching contactor. The busbar 12 is elongate, preferably formed of metal, such as brass, steel or copper, and may be straight, curved or a combination thereof.

Preferably, the busbar 12 has a length L1 having a first dimension which begins and ends at end faces 20, a width W1 having a second dimension, and a height H having a third dimension. The width W1 and height H are preferably mutually perpendicular to each other as well as to the length L1, with the first dimension being greater than the second and third dimensions, and the second dimension being less than the third dimension. This consequently allows the busbar 12 or other suitable primary conductor to define a rectangular or substantially rectangular cross-section laterally to and along a portion, preferably being at least a major portion, of the longitudinal extent.

Although preferably rectangular or substantially rectangular, the primary conductor may be of another polygonal or substantially polygonal lateral cross-section. However, a rectangular or substantially rectangular lateral cross-section is most beneficial due to the cross-section being elongate thereby providing opposing flat or planar minor-sides 22 extending between the two opposing end faces 20 or at least along a portion of the longitudinal extent. The flat minor-sides 22 define the aforementioned width W1, in this case.

A further benefit of the rectangular or substantially rectangular lateral cross-section is the provision of the opposing flat or planar major-sides 24 extending between the two opposing end faces 20 or at least along a portion of the longitudinal extent, and preferably perpendicularly to the flat minor-sides 22. The flat major-sides 24 define the aforementioned height H, in this case.

The first and second field-modifying elements 14, 16 may conveniently be formed of magnetic material, and in this case are preferably rigid or stiff planar or substantially planar plates 14a, 16a. The plates 14a, 16a in this case may be formed from a magnetisable material, that is, a soft magnetic material such as iron, cobalt, nickel or steel. Equally, though, the plates 14a, 16a may be formed from a hard magnetic material, such as a permanent magnet, for instance a rare-earth magnet such as a neodymium iron boron or samarium cobalt magnet.

Although continuous or unbroken planar plates 14a, 16a are suggested, in this case being preferably rectangular, it may be feasible to utilise non-planar plates or to have at least a portion which is non-planar, which may allow for further modification of the induced-electromagnetic field when a current flows in the primary conductor 12. This is described in further detail hereinafter.

Additionally or alternatively, the plates may be discontinuous or have openings, as may be required. Again, it may become apparent that this again allows for further tuning of the generated electromagnetic field.

To preferably support the first and second field-modifying elements 14, 16 at or adjacent to the flat minor-sides 22 of the primary conductor 12, and preferably overlapping or extending beyond the width W1 of the flat minor-sides, the two said sensing coils 18a, 18b are provided, in this case preferably clipped in spaced relationship to the primary conductor 12. The sensing coils 18a, 18b may be provided with a bobbin former 26 around which electrically conductive wire 28 is coiled multiple times so as to be tightly packed, typically with a plurality of overlying turns or runs.

At each end of the former 26 may be provided a, preferably elongate, holder 32 for receiving ends or sides of the first and second field-modifying elements 14, 16. Generally, the holder 32 may conveniently include a recess 34 within the body of the holder 32. The recess 34 may be slot shaped, and sufficiently dimensioned to receive a portion of one of first and second field-modifying elements 14, 16 as a complementarily fit. The dimensions of the recess 34 may allow for a tolerance or close fit of the respective first and second field-modifying elements 14, 16.

With the first and second field-modifying elements 14, 16 engaged with respective ends of the first and second sensing coils 18a, 18b, the coils 18a, 18b are then physically or mechanically connected directly to the primary conductor 12 via their hangers 36, which as mentioned above may beneficially be in the form of clips or brackets 36a.

The clips or brackets 36a are in the form of elongate rigid or semi-rigid arms 38, preferably cantilevered from the formers 26 to project towards an opposing sensing coil 18a, 18b. The clips or brackets 36a are offset from each other, and are located over the minor-sides 22 to hold the sensing coils 18a, 18b in spaced relationship with their respective major-sides 24.

Although an air gap is present between the sensing coils 18a, 18b and the major-sides 24 of the primary conductor 12, the sensing coils may be mounted directly to their respective major-sides. In this case, it is preferable that an electrically insulated layer or member is provided to electrically isolate each sensing device from the primary conductor to prevent or inhibit direct current flow thereto.

The hangers 36 are beneficial in that the sensing coils 18a, 18b may thus be demountable from the primary conductor 12. However, a permanent fastening may be considered, as necessity dictates, and which may, for example, take the form of a bracket which is permanently attached to the primary conductor 12, such as by welding, bonding or via one or more screw-threaded fasteners.

Although two sensing coils 18a, 18b are preferred to provide improved resolution, only one sensing coil or other suitable sensing device or means may be utilised.

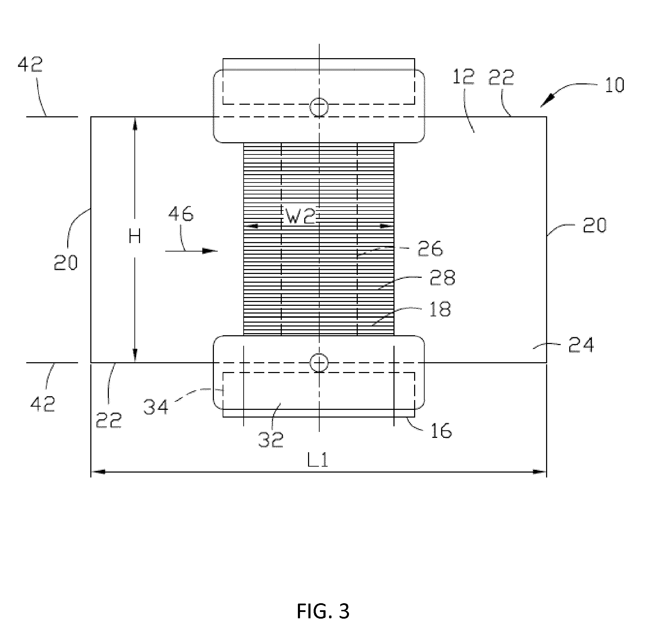

As best seen in Figure 3, each sensing coil 18a, 18b has a width W2 which is preferably greater than its depth D. A length L2 of the sensing coils 18a, 18b, and therefore the respective coil axes 40, also extend to or substantially to planes 42 of the minor-sides 22. A lateral extent of each sensing coil 18a, 18b is thus preferably polygonal or substantially polygonal, and more preferably rectangular or substantially rectangular, in this case uniformly or substantially uniformly along at least a majority of the coil length L2.

From each coil end, a secondary conductor 44 extends thereby allowing a voltage signal to be monitored based on an induced electromotive force, also referenced herein and throughout as 'EMF'.

Although it has been suggested that a lateral cross-section of the busbar 12 or other primary conductor is rectangular or substantially rectangular, provided the minor-sides are utilised, it may be feasible that the major-sides are arcuate or partially arcuate, if required.

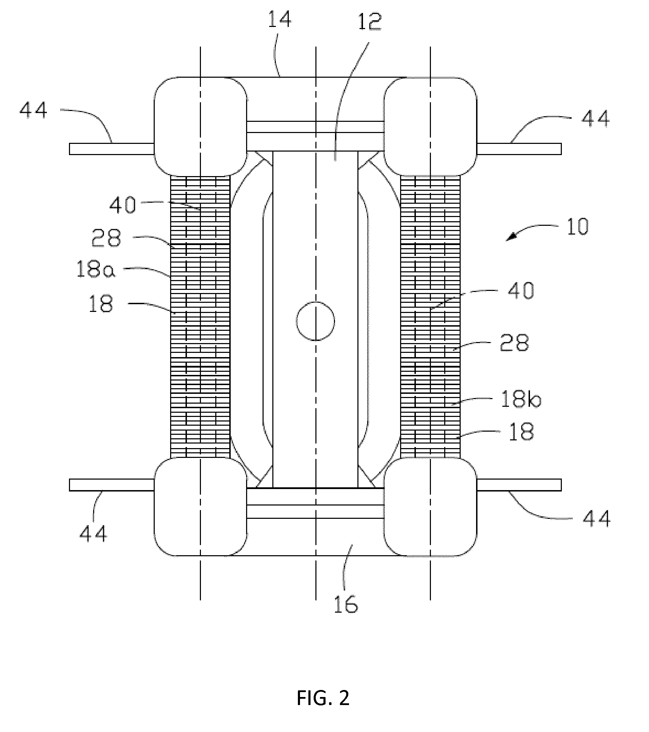

In use and with a current flowing between the end faces 20 of the flat-sided primary conductor 12, thereby defining a flow direction 46, an electromagnetic field F induced by the current in the flat-sided primary conductor 12 is modified by the first and second field-modifying elements 14, 16. As can be understood from Figures 1 and 2, the electromagnetic field F is manipulated or re-shaped to extend more in parallel or substantially in parallel with the coil axes 40 of the sensing coils 18a, 18b. See Figure 1, by way of example, which shows a representation of the field F with the sensing coils 18a, 18b demounted.

With the sensing coils 18a, 18b mechanically connected to the primary conductor 12, an induced electromotive force is realised, thereby allowing a voltage signal to be outputted. The induced electromotive force and thus the associated monitored voltage have improved proportionality with the current flowing in the primary conductor 12, due to the combination of the rectangular or substantially rectangular lateral cross-section of the primary conductor 12 and the, preferably overhanging, first and second field-modifying elements 14, 16 manipulating the produced field to, as mentioned above, extend more in parallel or substantially in parallel with the coil axes 40 of the sensing coils 18a, 18b. An improved resolution or accuracy of the monitored voltage being proportional to the current flowing in the primary conductor 12 is thus achieved.

As a consequence of this, to maintain a current or presently monitored voltage resolution or accuracy, which may in fact be sufficient or adequate for a required application, the sensing coils 18a, 18b can actually be reduced in volume or size. This thereby enables not only material and manufacturing time and cost-saving during the production of the sensing coils 18a, 18b, but also the primary conductor 12 may also be reduced in size with similar benefits being achieved.

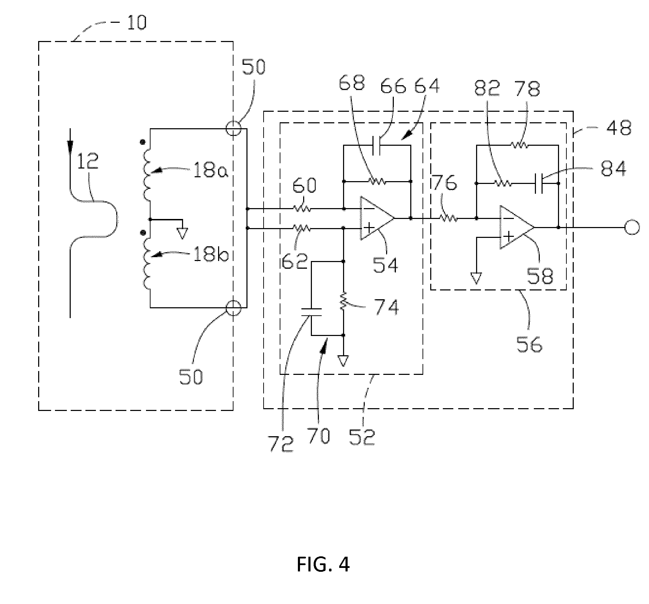

As shown in Figure 4, a corrector circuit 48 may be utilised in combination with the current determining device 10 described above. This would be beneficial due to the output signal in the secondary conductors 44 being 90 degrees lagging and thus out of phase with the current to be measured or monitored in the primary conductor 12.

To this end, the corrector circuit 48 preferably includes a signal input 50 for receiving an output signal from the sensing coils 18a, 18b corresponding to an induced voltage, a differential-phase correction integrator circuit 52 having a first operational amplifier 54, also called an op-amp, and a scaling calibration circuit 56 having a second operational amplifier 58.

The differential-phase correction integrator circuit 52 preferably utilises the first operational amplifier 54 having its inputs connected to outputs of the sensing coils 18a, 18b through first and second resistors 60, 62. The sensing coils 18a, 18b are represented by differentially connected inductors. A first parallel RC-circuit 64 comprising a first capacitor 66 and a third resistor 68 is provided in a negative feedback loop of the first operational amplifier 54. A second parallel RC-circuit 70 comprising a second capacitor 72 and fourth resistor 74 is connected between ground and the noninverting input of the first operational amplifier 54.

To allow for scaling, if required, the second operational amplifier 58 has an inverting input connected to the output of the first operational amplifier 54 through a fifth resistor 76. A negative feedback loop of the second operational amplifier 58 comprises a sixth resistor 78 connected in parallel with a series RC-circuit 80 comprising a seventh resistor 82 and third capacitor 84. The values of the circuitry components depends on the scaling calibration required.

Although it is suggested that the field-modifying elements are held in spaced relationship with the minor or narrower flat sides of the primary conductor, they may feasibly be mounted directly to the flat sides, for example, by utilising an electrically isolating layer interposed therebetween. Furthermore, although it is suggested that the field-modifying elements are positioned at or adjacent to the minor flat-sides, and the sensing device is position adjacent to one or more of the major flat-sides, this may feasibly be reversed, dependent on necessity.

The sensing means, which in this case is one or more coils, preferably provides a non-circular lateral cross-section along the axis of the former or bobbin. However, other cross-sectional winding shapes are feasible, such as circular. However, a benefit of the elongate wound cross-section is that an increased activate area or volume of the sensing means is achieved.

It is thus possible to provide a current determining device which better manipulates the induced magnetic field formed by a current carrying conductor, in this case being preferably a busbar of a switch. This is achieved by having at least two opposing flat sides at or adjacent to which field-modifying elements can be located. Preferably, the opposing flat sides are minor or narrower sides of the current-carrying primary conductor to be monitored, forming part of a polygonal, preferably rectangular, cross-section. The current determining device enables a more parallel field to be achieved, thereby achieving a more accurate or higher resolution current measurement sensor within the active dimensions of the sensing coils. It is therefore possible to maintain an existing resolution or accuracy of the current determination within the in use primary conductor, whilst reducing the size of the sensing coils, if necessary. It is further possible to provide the at least one sensing device, which is preferably two sensing coils, in a demountable or removable clipped arrangement with the current-carrying primary conductor, thus enabling simple and time-efficient location and relocation during manufacture of the current determining device or retrospective addition to an existing busbar or other primary conductor. It is additionally possible to provide an improvement in current determination, accuracy, monitoring and/or resolution due to improved proportionality of the induced voltage in the sensing coil or other suitable induced-EMF sensing or monitoring device relative to the current flowing in the flat-sided primary conductor.

The words 'comprises/comprising' and the words 'having/including' when used herein with reference to the present invention are used to specify the presence of stated features, integers, steps or components, but do not preclude the presence or addition of one or more other features, integers, steps, components or groups thereof.

It is appreciated that certain features of the invention, which are, for clarity, described in the context of separate embodiments, may also be provided in combination in a single embodiment. Conversely, various features of the invention which are, for brevity, described in the context of a single embodiment, may also be provided separately or in any suitable sub-combination.

The embodiments described above are provided by way of examples only, and various other modifications will be apparent to persons skilled in the field without departing from the scope of the invention as defined by the appended claims.

## Claims

1. A current determining device (10) comprising:
a flat-sided primary conductor (12) having two end faces (20) between which a current can flow in a flow direction and at least two flat sides (22) in parallel with the flow direction;
a first field-modifying element (14) formed of a magnetic material and located at or adjacent to a first said flat side (22) of the primary conductor (12) (12);
a second field-modifying element (16) formed of a magnetic material and located at or adjacent to the second said flat side (22) of the primary conductor (12); and
at least one sensing coil (18a, 18b) at or adjacent to the primary conductor (12) and the first and second field-modifying elements (14, 16), and having a coil axis (40) which extends between planes of the two flat sides (22),
wherein an electromagnetic field (F) formed by current flowing in the flat-sided primary conductor (12) is modified by the first and second field-modifying elements (14, 16) to extend more in parallel or substantially in parallel with the coil axis (40) of the sensing coil (18a, 18b), whereby an induced-EMF at the sensing coil (18a, 18b) has improved proportionality with the current flowing in the flat-sided primary conductor (12)

2. A current determining device (10) as claimed in claim 1, wherein the flat-sided primary conductor (12) has a rectangular or substantially rectangular cross-section lateral to the flow direction at at least the sensing coil (18a, 18b).

3. A current determining device (10) as claimed in any one of the preceding claims, wherein the flat-sided primary conductor (12) is a busbar, the busbar forms part of an electrical disconnect switch.

4. A current determining device (10) as claimed in any one of the preceding claims, wherein the first and second field-modifying elements (14, 16) are formed from a magnetisable material or a permanent magnetic material, and the first and second field-modifying elements (14, 16) are plates.

5. A current determining device (10) as claimed in any one of the preceding claims, wherein the first and second field-modifying elements (14, 16) are spaced from the flat-sided primary conductor (12).

6. A current determining device (10) as claimed in any one of the preceding claims, further comprising a second sensing coil (18a, 18b) at or adjacent to the primary conductor (12) and the first and second field-modifying elements(14, 16), and having a coil axis (40) which extends between planes of the two flat sides.

7. A current determining device (10) as claimed in claim 6, wherein the first said sensing coil (18a) and the second sensing coil (18b) are positioned on opposite sides of the flat-sided primary conductor (12) and the first and second sensing coils (18a, 18b) face each other.

8. A current determining device (10) as claimed in any one of the preceding claims, wherein the said at least one sensing coil (18a, 18b) has a rectangular or substantially rectangular cross-section lateral to the coil axis.

9. A current determining device (10) as claimed in any one of the preceding claims, wherein the said at least one sensing coil (18a, 18b) includes at least one hanger (36) by which the or each sensing coil (18a, 18b) is engagable with the flat-sided primary conductor (12).

10. A current determining device (10) as claimed in claim 9, wherein the hanger (36) is a clip.

11. A current determining device (10) as claimed in any one of the preceding claims, wherein the said at least one sensing coil (18a, 18b) includes a holder for holding the first and second field-modifying elements (14, 16) in spaced relationship with the flat-sided primary conductor (12).

12. A current determining device (10) as claimed in claim 11, wherein the holder is a recess at each end of the at least one sensing coil (18a, 18b) in which a respective end of the first and second field-modifying elements (14, 16) is receivable.

13. A corrector circuit (48) in combination with a current determining device (10) as claimed in any one of the preceding claims, the corrector circuit (48) having an input (50) for receiving an output signal corresponding to an induced-EMF from the or each sensing coil (18a, 18b), and a differential-phase correction integrator circuit (53) having an op-amp (54) and which alters a phase-difference of the output signal, so that an altered output signal can be formed in-phase or substantially in-phase with the current in the primary conductor (12).

14. A combination as claimed in claim 13, wherein the corrector circuit (48) includes a scaling calibration circuit (56) for calibrating and scaling the altered output signal, the scaling calibration circuit (56) including a further op-amp (58).

15. A method of improving current determination using a current determining device (10) as claimed in any one of claims 1 to 12, the method comprising the steps of modifying an electromagnetic field formed by a current-carrying primary conductor (12) by utilising opposing flat sides on the current-carrying primary conductor (12) and associated first and second field-modifying elements (14, 16), whereby the electromagnetic field is more in parallel or substantially in parallel with a coil axis of an associated sensing coil (18a, 18b), thereby improving the proportionality of the induced-EMF at the sensing coil (18a, 18b) relative to the current flowing in the flat-sided primary conductor (12).
